# EUROPÄISCHE PATENTSCHRIFT

(11) **EP 0 700 076 B1**
(45) Veröffentlichungstag und Bekanntmachung des Hinweises auf die Patenterteilung: **16.08.2000**
(21) Anmeldenummer: 95103066.7
(22) Anmeldetag: 03.03.1995
(51) Int. Cl.: H01L 21/00

(54) **Beschickungseinrichtung für Halbleiterbearbeitungsanlagen**
Loading device for semiconductor treatment installations
Dispositif de chargement pour installations de traitement de semi-conducteurs

(30) Priorität: 31.08.1994 DE 4430844
(43) Veröffentlichungstag der Anmeldung: 06.03.1996
(73) Patentinhaber: JENOPTIK Technologie GmbH, D-07745 Jena (DE)
(72) Erfinder: Scheler, Werner, D-07743 Jena (DE); Schlehahn, Volker, D-07747 Jena (DE); Fabian, Peter, D-07745 Jena (DE); Weske, Hans-Joachim, D-07747 Jena (DE)
(74) Vertreter: Geyer, Werner, Dr.-Ing.

(56) Entgegenhaltungen:
- EP-A- 0 253 162
- US-A- 3 913 749
- US-A- 5 064 337

## Beschreibung

Die Erfindung betrifft eine Beschickungseinrichtung für Halbleiterbearbeitungsanlagen bei der zur Umsetzung eines Transportobjektes zwischen zwei Endlagen ein feststehendes Teil ein zwischen den Endlagen durch einen Antrieb linear bewegliches Teil trägt, wobei an dem beweglichen Teil ein Greifer für das Transportobjekt befestigt ist.

Bei der Herstellung integrierter Schaltkreise müssen Halbleiterscheiben zwischen unterschiedlichen Bearbeitungsschritten zu einzelnen Bearbeitungsmaschinen transportiert werden. In zunehmendem Maße geschieht dies in standardisierten Transportbehältern, sogenannten Standard Mechanical Interface Boxen (SMIF-Boxen), da anstelle der Optimierung konventioneller Reinräume in Richtung höherer Reinheitsklassen zur Erzielung größerer Integrationsdichten die konsequente Durchsetzung des Einsatzes von Einhausungen oder der Einsatz der SMIF-Technologie in den Halbleiterbearbeitungsanlagen einen Weg darstellt, um höhere Ausbeuten zu vertretbaren Kosten zu erreichen.
Die Halbleiterscheiben sind in Fächer eines Magazins eingeschoben, das auf dem Boden der SMIF-Box in geeigneter Weise fixiert ist.

Zur Beschickung der Halbleiterbearbeitungsanlagen erfolgt zunächst eine Entnahme der Magazine aus den Transportbehältern. Danach ist in der Regel eine Umsetzung notwendig, zu deren Durchführung verschiedene technische Lösungen bekannt geworden sind.
So wird nach EP 209 660 eine Kassette durch einen automatisierten Kassettenmanipulator von einem SMIF-Fahrstuhl zu einem Gerätefahrstuhl transportiert, indem eine Schwenkbewegung während der senkrechten Auf- oder Abbewegung der Kassette eingesetzt wird. Durch den Einsatz von Drehelementen soll das Maß der Partikelerzeugung gegenüber linear sich bewegenden Elementen herabgesetzt werden.
Ähnliche Lösungen sind auch in EP 238 541 beschrieben, bei denen das Umsetzen des Magazins über vorgegebene Bewegungskurven durch den Einsatz motorisch angetriebener Hebelarme erfolgt, die mit einem separaten Lift in z-Richtung verfahren werden.

Durch die mechanische Ausführung der bekannten Lösungen, insbesondere den seitlich am Magazin vorbeigefährten Wirkbereich des als Hebelarm ausgebildeten Umsetzers bzw. den geschlossenen Aufbau wird die zum Erhalt des Reinstraumes erforderliche Laminarluftströmung stark gestört oder verhindert.
Die Kopplung der Umsetzbewegung mit der z-Bewegung verlängert unnötig die Transportzeiten und erhöht die Partikelgenerierung.
Außerdem ist es mit den bekannten Lösungen schwierig, bei der Nachrüstung von Halbleiterbearbeitungsanlagen bereits bestehende Reinsträume mit dem SMIF-System zu komplettieren, so daß Wafermagazine unter SMIF-Bedingungen in die Maschinen eingebracht und dort unter Reinstraumbedingungen entpackt und transportiert werden können.

Nach der DE-Patentschrift 43 26 309 C1 ist eine technische Lösung bekannt, bei der zur Umsetzung des Magazins von einer Abstellposition zu einem Bearbeitungplatz an einer tragenden Säule ein in Fahrtrichtung des Fahrstuhles höhenverstellbarer Linearantrieb für einen starren Greiferarm befestigt ist. Der Aktionsbereich des Greiferarmes liegt oberhalb des sich in der Abstellposition befindlichen Magazins und ist senkrecht zur Fahrtrichtung des Fahrstuhles gerichtet. Zwischen der tragende Säule und einem Fahrstuhlantrieb ist eine Luftdurchtrittsöffnung vorgesehen. Alle Antriebsteile sind durch eine staubdichte Kapselung vom Reinstraum getrennt, und an Öffnungen, durch die Transportelemente in den Reinstraum ragen, grenzen Absaugeinrichtungen an.

Zwar werden die vorstehend genannten Nachteile beseitigt, doch erfordern die Halbleiterbearbeitungsanlagen in ihrer Vielfalt auch unterschiedliche Beschickungs- und Abstellvarianten für die Magazine.
Außerdem können bei länger werdenden Transportwegen mitgeführte Kabel für die Signal- und Motorstromübertragung von dafür vorgesehenen Einrichtungen im feststehenden Teil der Vorrichtung auf den beweglichen Teil, insbesondere den Greifer mit seinen greifenden Elementen, zu Störungen führen und die Zuverlässigkeit negativ beeinflussen. Von Nachteil ist außerdem die mechanische Rückwirkung der Kabelverbindung auf das bewegliche Teil und die Möglichkeit einer Partikelgenerierung.

Desweiteren haben pneumatisch betriebene Linearantriebe den Nachteil, in Endlagen beidseitig des Zylinders auf sehr kurzem Weg durch eine Geschwindigkeitssteuerung mittels Drosselrückschlagventilen in Form einer Endlagendämpfung abzubremsen. Dabei wird von der maximalen Geschwindigkeit auf einem Weg von wenigen Millimetern auf Null abgebremst. Es entstehen unvermeidbare Stöße auf das Transportobjekt.

Aus US-A-5 064 337 und EP-A-0 253 162 sind weitere Beschickungseinrichtungen bekannt. In der jeweiligen Einrichtung ist ein an einem linear beweglichen Greiferarm drehbar befestigter Greifer vorgesehen. Ein Transportobjekt wird mit dem Greifer ergriffen, und durch Linear- und Drehbewegungen des Greifers von einer Lage zu einer anderen transportiert.

Aufgabe der Erfindung ist es deshalb, die Flexibilität bei der Beschickung bei Ausschluß sich negativ auf die Zuverlässigkeit und die Reinstraumbedingungen auswirkender Einflüsse zu erhöhen.

Die Aufgabe wird durch eine Beschickungseinrichtung für Halbleiterbearbeitungsanlagen gemäß Anspruch 1 gelöst, bei der zur Umsetzung eines Transportobjektes zwischen zwei Endlagen ein feststehendes Teil ein zwischen den Endlagen durch einen Antrieb linear bewegliches Teil trägt, wobei an dem beweglichen Teil ein Greifer für das Transportobjekt befestigt ist, indem zumindest in einem Abschnitt der Bewegung des beweglichen Teiles mit der Linearbewegung eine rotatorische Bewegung des Greifers verbunden ist.

Zwischen dem Greifer und einem Greiferarm, an dem der Greifer drehbar befestigt ist und der die Verbindung zu dem Antrieb herstellt, besteht eine mechanische Kopplung, die die Linearbewegung des Greifers mit der rotatorischen Bewegung des Greifers verknüpft.

In einer ersten Ausführung weist die drehbare Befestigung des Greifers am Greiferarm eine parallel zur Ebene der Linearbewegung und senkrecht zur Linearbewegung selbst gerichtete Drehachse auf.

Für diese Ausführung ist es von Vorteil, wenn zur mechanischen Kopplung der rotatorischen Bewegung des Greifers mit der Linearbewegung ein mit dem Greiferarm verbundener erster Hebel vorgesehen ist, der während der Linearbewegung eine Kulisse, die eine Höhendifferenz aufweist, abtastet, und der über eine drehbar befestigte Schubstange mit einem am Greifer befestigten zweiten Hebel zur Übertragung der Höhendifferenz und Umformung in die rotatorische Bewegung verbunden ist.

Zur Einstellung des Drehwinkels des Greifers kann der erste Hebel in seiner wirksamen Hebellange einstellbar sein.

In einer zweiten Ausführung weist die drehbare Befestigung eine senkrecht zur Ebene der Linearbewegung gerichtete Drehachse auf.

Für diese zweite Ausführung sind vorteilhafterweise an einer, in Kugelumlaufführungen geführten und gelagerten Zugstange ein Mitnehmer für eine am Greifer in einer außermittigig angeordneten Kugelgelenkverbindung gelagerte Koppelstange und ein erster Anschlag befestigt, der bei vorwärtiger Linearbewegung des Greiferarms durch seine Anlage an einem zweiten Anschlag am festen Teil ein Zurückbleiben der Zugstange und des Mitnehmers verursacht. Im Ergebnis erfolgt die Drehung des Greifers in der drehbaren Befestigung.
Außerdem weist die Kugelgelenkverbindung ein federkraftbeaufschlagtes, justierbares Anschlagsystem auf.

Der Ort des Beginns der Rotation und der Drehwinkel ist durch Variation der Befestigung sowohl des ersten Anschlages an der Zugstange als auch des zweiten Anschlages an der Grundplatte oder der Änderung der Lage der Koppelstange einstellbar.

Zur Steuerung der Funktionen des Greifers erfolgt vorzugsweise eine elektrische Kontaktierung zwischen Sensoren und Aktoren des Grerfers und einer Versorgungseinheit zur Signal- und Motorstromversorgung am feststehenden Teil ausschließlich in den beiden Endlagen des beweglichen Teiles.

Für die elektrische Kontaktierung sind Baugruppen mit federnden Kontakten vorgesehen, von denen das feststehende Teil in den Endlagen des beweglichen Teiles jeweils eine Baugruppe und das bewegliche Teil mindestens eine weitere Baugruppe trägt, wobei die federnden Kontakte am feststehenden Teil, die elektrisch mit der Versorgungseinheit verbunden sind, den federnden Kontakten am beweglichen Teil, von denen elektrische Verbindungen zu den Sensoren und Aktoren bestehen, zugewandt sind.

Durch den Ersatz von sonst üblicherweise notwendigen mitgeführten Spiralkabeln durch diese kontaktgruppen und die Herstellung einer elektrischen Kontaktierung nur in den Enlagen wird die Zuverlässigkeit der Einrichtung wesentlich erhöht, da Kabelbrüche, die infolge der starken mechanischen Beanspruchung der mitgeführten Kabel auftreten können, ausgeschlossen werden. Positiv wirkt sich auch aus, daß durch diesen Ersatz eine weitere Quelle der Partikelgenerierung ausgeschaltet ist.

Vorteilhafterweise sind die federnden Kontakte als Goldkontakte ausgebildet, in Form von federnd in einer Hülse gehaltenen Goldstiften.

Es ist von Vorteil, wenn für die Linearbewegung des Geifers ein pneumatischer Linearantrieb vorgesehen ist.
Zur Vermeidung von Stößen auf das Transportobjekt ist zur Geschwindigkeitssteuerung für jede Richtung der Linearbewegung am Zylinder des pneumatischen Linearantriebes mindestens ein Paar von parallel wirkenden Drosseln mit voneinander verschieden einstellbaren Luftdurchlaßmengen vorgesehen. Die Zahl der in Richtung der Linearbewegung wirksam werdenden Drosseln ist in Abhängigkeit vom Ort des beweglichen Teiles und der Richtung der Linearbewegung von Sensorsignalen gesteuert.

Von Vorteil ist es wenn als Drosseln Drosselrückschlagventile vorgesehen sind, die die Drosselung von Abluft einstellbar zulassen und Luft in Bewegungsrichtung ungehindert durchlassen.

Die Erfindung soll nachstehend anhand der schematischen Zeichnung naher erläutert werden. Es zeigen:
- Fig. 1: eine Ansicht einer Beschickungseinrichtung zur Drehung eines Magazin in eine "Rückenlage" mit beweglichem Teil in einer Endlage
- Fig. 2: die Beschickungseinrichtung gemäß Fig. 1 mit beweglichem Teil in der anderen Endlage
- Fig. 3: in vergrößerter Darstellung die mechanische Kopplung der Drehbewegung in die "Rückerlage" an die Linearbewegung
- Fig. 4: in Blockdarstellung die Geschwindigkeitssteuerung des Antriebes
- Fig. 5: eine Ansicht einer Bechickungseinrichtung zur Drehung eines Magazins um eine senkrecht zur Ebene der Linearbewegung gerichtete Achse mit beweglichem Teil in einer Endlage
- Fig. 6: die Beschickungseinrichtung gemäß Fig. 5 mit beweglichem Teil in der anderen Endlage

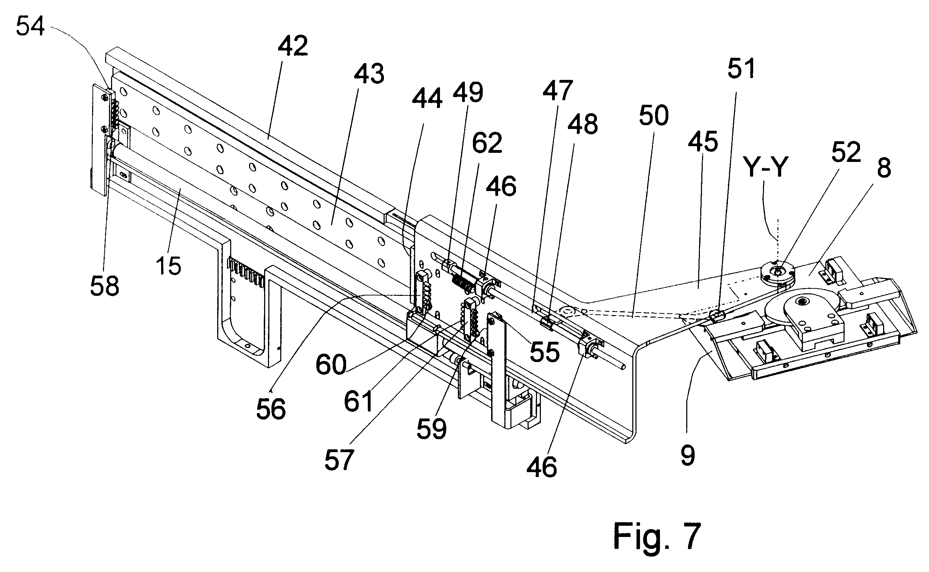

- Fig. 7: in vergrößerter Darstellung die mechanische Kopplung der Drehbewegung um eine senkrecht zur Ebene der Linearbewegung gerichtete Achse an die Linearbewegung

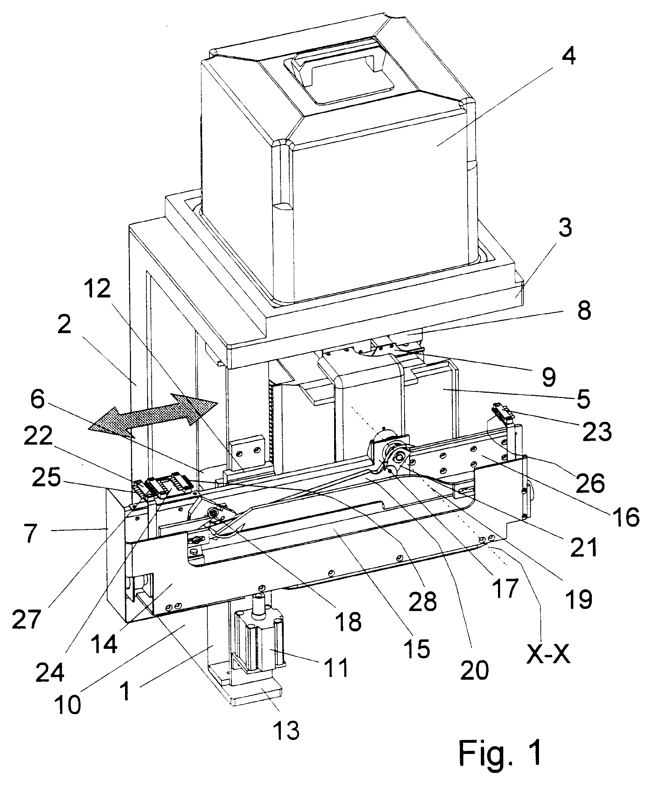

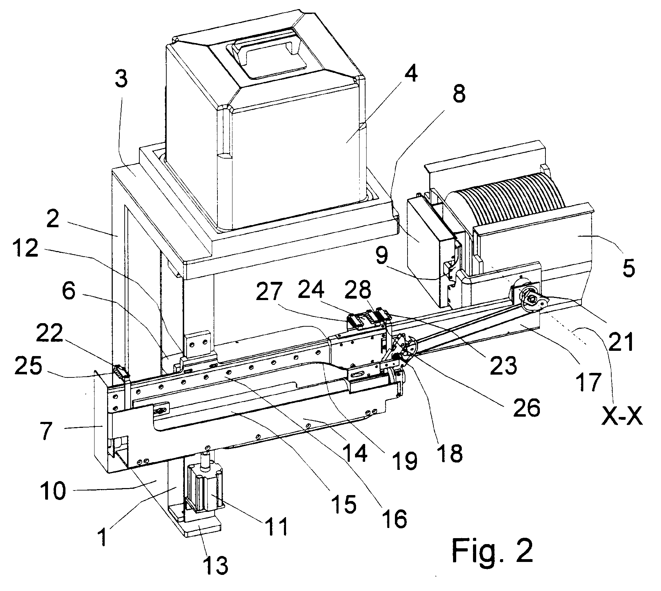

In den Figuren 1 und 2 dienen eine tragende Säule 1 und ein verkleideter Fahrstuhlantrieb 2, deren Abstand zueinander eine Luftdurchtrittsöffnung darstellt, als Abstützelemente für eine Aufnahme 3, auf die ein Magazinbehälter 4 abgestellt ist.
Ein durch den Fahrstuhlantrieb 2 in z-Richtung verfahrbarer, in der DE-Patentschrift 43 26 309 C1näher beschriebener Fährstuhl mit einem Aufnahmearm ist vorgesehen, um die Entnahme und Rückführung eines in dem Magazinbehälter 4 befindlichen Magazins 5 für waferartige Objekte auszuführen.
In den vorliegenden Darstellungen ist das Magazin 5 aus dem Magazinbehälter 4 zusammen mit dessen Boden entnommen und steht auf einer aus der Aufnahme 3 heraus absenkbaren Platte 6, die für die SMIF-Technologie notwendige Aktoren und Sensoren enthält. So ist es z. B. erforderlich, den Zustand zu erfassen, ob ein Magazinbehälter 4 abgestellt ist oder nicht oder ob dieser geöffnet oder geschlossen ist.
Der Fahrstuhl besitzt einen beweglichen Teil, der in einem feststehenden Teil geführt, zwischen einer oberen Entnahme- und Rückführungsposition und einer unteren Abstellposition verfahrbar ist. Die obere Entnahme- und Rückführungsposition und die untere Abstellposition entsprechen jeweils einer ersten und einer zweiten Endlage des beweglichen Teiles des Fahrstuhles.
An der tragenden Säule 1 ist ein Linearantrieb 7 für einen beweglichen Greifer 8 befestigt, dessen Aktionsbereich oberhalb des sich in der unteren Abstellposition befindlichen Magazins 5 liegt und senkrecht zur Fahrtrichtung des Fahrstuhlantriebes 2 gerichtet ist.
Der Greifarm 8 ist mit den greifenden Elementen 9 und hier nicht dargestellten Sensoren zur Überwachung des Greifvorganges versehen.
Im unteren Bereich zwischen der Säule 1 und den Fahrstuhlantrieb 2 ist eine Versorgungseinheit 10 zur Signal- und Motorstromversorgung für den Linearantrieb 7, den Greifer 8 mit seinen greifenden Elementen 9 und einem zur z-Verstellung dienenden pneumatischen Kurzhubzylinder 11 mit einer Wälzführung 12 untergebracht.
Mit einer Grundplatte 13 ist die gesamte Einrichtung über ein mechanisches Interface an einer Halbleiterbearbeitungsanlage befestigbar.
Zur Erzeugung des mit einem Pfeil gekennzeichneten Luftstromes kann zwischen der Säule 1 und dem Fahrstuhlantrieb 2 eine Absaugvorrichtung oder eine Filter/Lüfter-Einheit angebracht werden, deren Drehzahl regelbar sein kann.
Im Bereich der Aufnahme 3 sind Bedien- und Anzeigeelemente untergebracht. Eine externe Steuerelektronik besitzt eine Kabelverbindung zu der Einrichtung, die aus einzelnen Modulen besteht, die durch unterschiedliche Kombinationen zu verschiedendsten Anlagen mit unterschiedlichsten Bewegungsabläufen montiert werden können; Es ist auch möglich, falls erforderlich, daß nur einzelne Bewegungsabläufe, wie z. B. die vertikale Bewegung des Fahrstuhles realisiert sind.

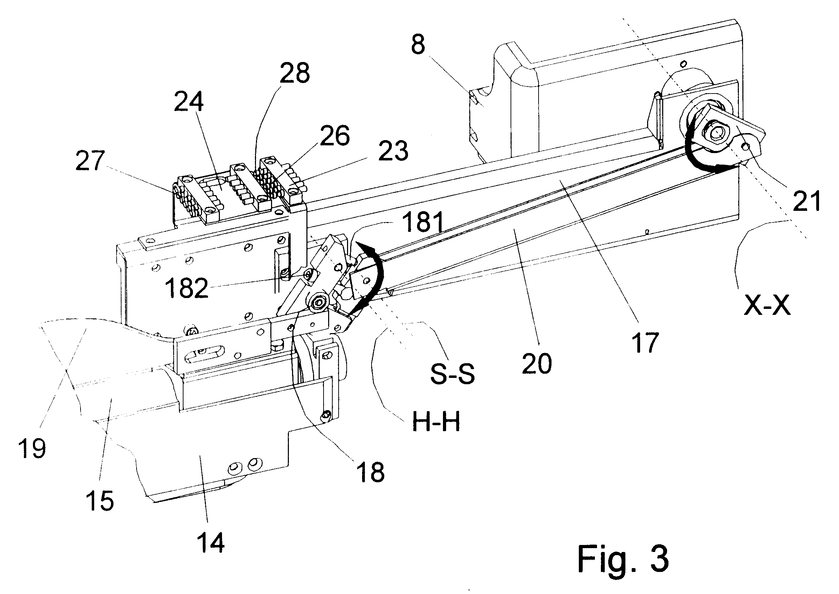

In dem Linearantrieb 7 nimmt eine tragende Grundplatte 14 einen pneumatischen Linearzylinder 15 mit einem innenliegenden beweglichen Kolben und eine zu diesem parallel angeordnete Walzführung 16 auf. Der Linearzylinder 15 und die Wälzführung 16 sind über einen Greiferarm 17 als beweglichen Teil miteinander verbunden, an dem der Greifer 8 in einem einstellbaren Winkelbereich um eine parallel zur Ebene der Linearbewegung und senkrecht zur Linearbewegung selbst gerichtete Achse X-X drehbar befestigt ist.
Zur Drehung des Greifers 8 um die Achse X-X ist, wie die vergrößerte Darstellung in Fig. 3 zeigt, ein um eine Achse H-H drehbarer erster Hebel 18 vorgesehen, der während der Linearbewegung eine Kulisse 19 abtastet. Die Kulisse 19 weist eine Höhendifferenz auf, die durch eine an dem ersten Hebel 18 um eine Achse S-S drehbar befestigte Schubstange 20 auf einen zweiten Hebel 21 übertragen wird, der wiederum die Verbindung zwischen der Schubstange 20 und den Greifer 8 herstellt.
Der erste Hebel 18 ist so konstruiert, daß seine wirksame Hebellänge und damit der Drehwinkel des Greifers 8 einstellbar ist. Über einen Einstellstift 181 wird der Abstand zwischen der Drehachse H-H des Hebels 18 und dem in der Achse S-S liegenden Eingriffspunkt der als Koppel dienenden Schubstange 20 verändert und mit einer Klemmschraube 182 fixiert.
Durch eine nicht sichtbare Zugfeder wird erreicht, daß der erste Hebel 18 immer an der Kulisse 19 anliegt und somit der Drehwinkel des gekippten Greifers 8 erhalten bleibt.

Nach Fig. 1 wird das Magazin 5, das dem Magazinbehälter entnommen ist und sich in der unteren Abstellposition befindet, von dem Greifer 8 mittels seiner motorisch bewegten greifenden Elemente 9 erfaßt, durch eine pneumatische Hubbewegung, erzeugt durch den Kurzhubzylinder 11, angehoben und durch den Linearantrieb 7 von einer ersten in eine zweite Endlage des beweglichen Teiles des Linearantriebes 7 (Magazinplatz der Halbleiterbearbeitungsanlage) transportiert.
Kurz vor Erreichen der zweiten Endlage erfolgt durch die Übertragung der Höhendifferenz H der Kulisse 19 auf den zweiten Hebelarm 21 eine Drehung des Greifers 8 und damit des Magazins 5 um die Achse X-X, so daß die vorher im Magazin 5 nach vorn entnehmbaren Halbleiterscheiben nun nach oben zeigen und so entnehmbar sind.
Die Drehung ist nach einem in der Länge bestimmten Linearweg beendet und die Endlage wird eingenommen. Es erfolgt über den Kurzhubzylinder 11 eine Absenkung und das Magazin 5 wird fixiert abgelegt.
Der Greifer 8 koppelt vom Magazin 5 ab und wird angehoben in seine Ruhestellung zurückgefahren. Der Fahrstuhlantrieb 2 hat den beweglichen Teil des Fahrstuhles vorher zusammen mit der Platte 6 und dem Boden des Magazinbehälters 4 wieder nach oben in seine erste Endlage gefahren, so daß der Magazinbehälter 4 geschlossen und somit zum Magazinwechsel freigegebenen ist.
Nach dem Einbringen eines Magazins in die Halbleiterbearbeitungsanlage kann diese die Schließung einer eventuell vorhandenen Schleusentür in ihrem Magazinbewegungsraum veranlassen, oder es werden weitere Magazine in die Halbleiteibearbeltungsanlage eingebracht.
Das Heraustransportieren der Magazine aus der Halbleiterbearbeitungsanlage erfolgt in umgekehrter Reihenfolge.

Zur Signal- und Motorstromübertragung von der Versorgungseinheit 10 zu Aktoren und Sensoren des Greifers 8 dienen Baugruppen 22, 23 und 24, von denen am feststehenden Teil in den Endlagen des beweglichen Teiles die Baugruppen 22 und 23 ortsfest montiert ist. Die Baugruppe 24 ist am Greiferarm 17 befestigt. Die Baugruppen 22, 23 weisen federnde Kontakte 25, 26 auf, die federnden Kontakten 27, 28 an der Baugruppe 24 zugewandt sind.
Von den federnden Kontakten 25, 26, die als Goldkontakte ausgebildet sind, in Form von federnd in einer Hülse gehaltenen Goldstiften, bestehen elektrische Verbindungen zur Versorgungseinheit 10 und von den Kontakten 27, 28 zu den Sensoren und Aktoren des Greifers 8.
Befindet sich der reifer in der Endlage gemäß Fig. 1, berühren sich die die Kontakte 25 und 27 und in der Endlage gemäß Fig. 2 die Kontakte 26 und 28 und ermöglichen die Signal- und Motorstromübertragung.
Die Goldstifte der Kontakte 27, 28 am beweglichen Teil setzen mit möglichst großem Druck auf ihr Gegenstück am feststehenden Teil auf, um einen kleinen Übergangswiderstand zu erreichen. Der erforderliche Kontaktdruck wird über die Feder erzeugt.
Der Arbeitshub, der durch die Federung erreicht wird, bewirkt, daß vor dem Verlassen der Endlagen noch kurzzeitiger elektrischer Kontakt besteht.
Während der Linearbewegung bzw. Drehung des Greifers 8 ist dessen elektrische Versorgung unterbrochen. Nur in den Endlagen ist die Versorgung des Greifers 8 gewährleiset, so daß ein Magazin übernommen bzw. übergeben werden.

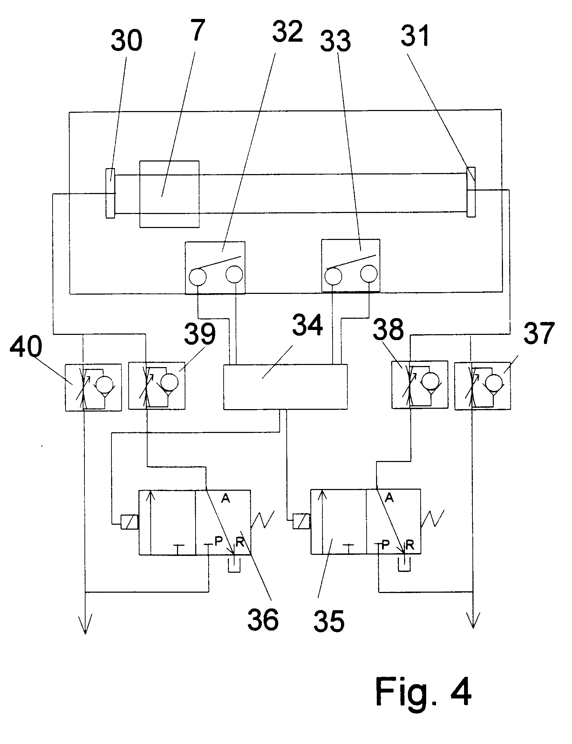

Zur Steuerung der Geschwindigkeit des pneumatischen Antriebes 7 sieht Fig. 4 eine Lösung vor, bei der entlang des Fahrweges des Kolbens zwei parallel zur Linearbewegung angeordnete und zu Endlagen 30, 31, die als feste Anschläge ausgebildet sind, justierbare Sensoren 32, 33 vor, die durch ein mit dem Kolben verbundenes Auslöseteil betätigt werden.
Von den Sensoren 32, 33 bestehen elektrische Verbindungen zu einer Elektronik 34, die die Impulssignale der Sensoren 32, 33 unter Beachtung der Fahrtrichtung in Signale zur Ansteuerung pneumatischer Ventile 35, 36 umwandelt. Mit jedem der pneumatischen Ventile 35, 36 ist ein Paar von Drosselrückschlagventilen 37, 38 und 39, 40 verbunden, die in der Abluftleitung des Zylinders angeordnet sind.
Bei einer Bewegung von der Endlage 30 in die Endlage 31 wird zunächst durch den Sensor 32 das Ventil 35 geöffnet, wodurch das Drosselrückschlagventil 38 dem Drosselrückschlagventil 37 zugeschaltet wird. Entsprechend der inneren Reibung des Antriebes und der Einstellung der Drosselrückschlagventile 37, 38 ergibt sich eine relativ hohe Endgeschwindigkeit des Kolbens.

Erfolgt die Bewegung über den Sensor 33 hinausgehend, wird das Ventil 35 geschlossen und damit das Drosselrückschlagventil 38 abgeschaltet. In Folge verringert sich die Geschwindigkeit des Kolbens bis zur Endlage 31 fast sinusförmig auf Null. Es wird ein sanftes Anfahren der Endlage 31 erreicht. Eine Erschütterung oder Bewegung der im Magazin zu transportierenden Wafer wird vermieden.
Ohne Einfluß bleibt vorerst ein mit dem Überfahren des Sensors 33 verbundenes Einschalten des Ventils 36. Erst bei umgekehrter Fahrtrichtung von der Endlage 31 zur Endlage 30 wird das durch die Einschaltung des Ventils 36 geöffnete Drosselrückschlagventil 39 wirksam, und es erfolgt ein Bewegungsablauf wie für die entgegengesetzte Richtung bereits beschrieben. Das bei Betätigung des Sensor 32 ausgelöste Signal schließt das Ventil 36 und der Kolben verringert infolge der Abschaltung des Drosselrückschlagventils 39 seine Geschwindigkeit und wird durch die Wirkung des Drosselrückschlagventils 40 bis zur Endlage 30 auf Null abgebremst.
In ähnlicher Weise wie schon bei der Fahrt von der Endlage 30 zur Endlage 31 hat ein erneutes, mit der Betätigung des Sensors 32 verbundene Öden des Ventils 35 vorerst keine Wirkung. Bei der Fahrt in entgegengesetzter Richtung wird dann das betätigte Drosselrückschlagventil 38 wirksam.
Durch die Festlegung des Abstandes der Sensoren 32, 33 von den Endlagen 30, 31 und die Einstellung der beiden jeweils zusammengehörenden Drosselrückschlagventile 37 und 38 bzw. 39 und 40 sind die erreichbaren Endgeschwindigkeiten bestimmbar.
Im vorliegenden Ausführungsbeispiel werden bei Abständen Endlage - Sensor von 90 ... 120 mm Geschwindigkeiten des Kolbens von 100 ... 150 mm/s realisiert.
Als Ventile werden 2/2-Wegeventile oder 3/2-Wegeventile mit einem verschlossenen Ausgang verwendet.
Die Drosselrückschlagventile 37, 38, 39 und 40 lassen jeweils die Drosselung der Abluft einstellbar zu, wobei die Luft in Bewegungsrichtung ungehindert passieren kann.
Die Drosselrückschlagventile 37 und 40 sind dabei so eingestellt, daß mit einem sogenannten "Kriechgang" (extra langsam) des Kolbens immer die jeweils anzufahrende Endlage erreicht wird.
Mit Hilfe der Elektronik 34 ist es auch möglich, eine Beeinflussung der Geschwindigkeit beim Anfahren des Kolbens zu erreichen. Die maximale Geschwindigkeit wird nur jeweils zwischen den zu durchfahrenden Positionen, an denen die Sensoren 22 und 31 angeordnet sind, erreicht. Das Hochfahren und das Abbremsen erfolgt in den Bereichen zwischen der Endlage 30 und dem Sensor 33 bzw. Sensor 32 und der Endlage 31 oder umgekehrt.
Mit dieser Lösung ist es mit einfachen Mitteln möglich, die Geschwindigkeit des Kolbens zu beeinflussen.

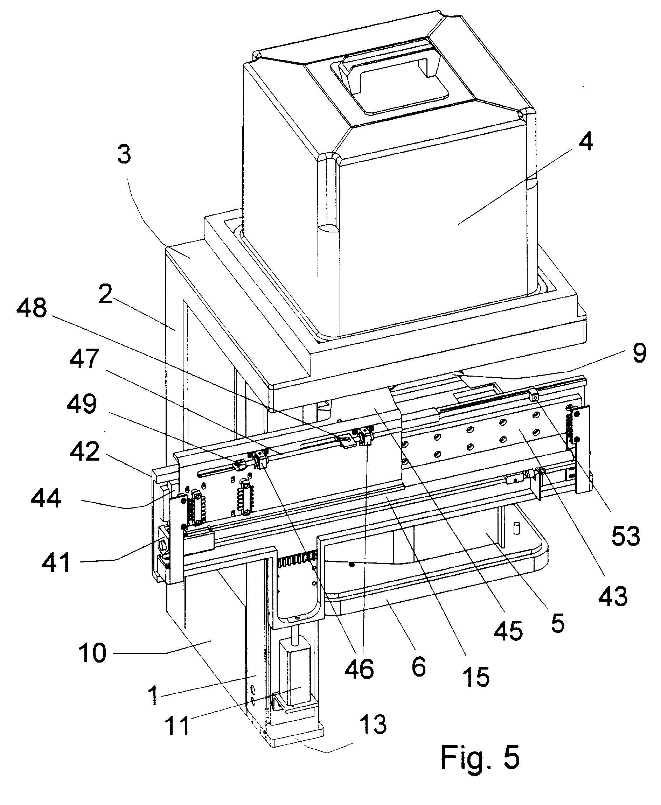

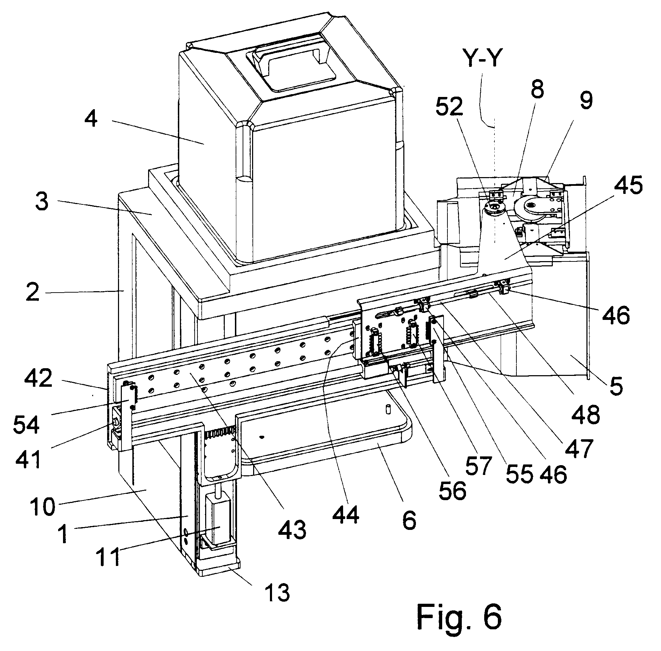

Das Ausführungsbeispiel nach den Figuren 5 und 6 verwendet zur Drehung des Magazins 8 um eine senkrecht zur Ebene der linearbewegung gerichteten Achse einen zum großen Teil gegenüber den Figuren 1 bis 3 konstruktiv verändert aufgebauten Linearantrieb 41. Da die gesamte Beschickungseinrichtung wie bereits beschrieben, modulartig aufgebaut ist, behalten unveränderte Bestandteile der Lösung ihre Bezugszeichen aus den Figuren 1 bis 3.

Der Linearantrieb 41, der ebenso wie der Linearantrieb 7 durch den Kurzhubzylinder 11 in einem Gleitlager höhenverstellbar ist, enthält auf einer Grundplatte 42 eine Führung 43 für einen Schlitten 44, an dem ein Greiferarm 45 befestigt ist. In seinem oberen Abschnitt weist der Greiferann 45 eine durch Kugelumlaufführungen 46 geführte und gelagerte Zugstange 47 auf, an durch den Greiferarm 45 hindurchgeführt, ein Mitnehmer 48 und ein erster Anschlag 49 befestigt sind.
Der Mitnehmer 48 ist über eine Koppelstange 50 mit dem Greifer 8 verbunden. Zur Lagerung für die Koppelstange 50 dient eine außermittig angeordnete Kugelgelenkverbindung 51, die ein federkraftbeaufschlagtes, justierbares Anschlagsystem aufweist. Der Greifer 8 ist durch ein Greiferlager 52, dessen Drehachse Y-Y senkrecht zur Ebene der Linearbewegung gerichtet ist, am Greiferarm 45 drehbar gelagert.
Auf der Grundplatte 42 ist ein zweiter Anschlag 53 so befestigt, daß bei vorwärtiger Linearbewegung des Greiferarms 45 in Richtung der Halbleiterbearbeitungsanlage der erste Anschlag 49 je nach seinem Ort der Befestigung auf der Zugstange 47 zur Anlage kommt. Dadurch bleibt die Zugstange 47 und damit der Mitnehmer 48 für die Koppelstange 50 bei weiterer Linearbewegung zurück und bewirkt eine rotatorische Bewegung der Greifers 8 um die Achse Y-Y der drehbaren Befestigung des Greifers 8 am Greiferarm 45.
Durch Variation der Befestigung sowohl des ersten Anschlages 49 an der Zugstange 47 als auch des zweiten Anschlages 53 an der Grundplatte 42 ist der Ort des Drehbeginns und der Drehwinkel einstellbar. Auch mit der Änderung der Lage der Koppelstange 50 ist ein derartiger Effekt verbunden.

Eine Zugfeder 62 ist mit dem Mitnehmer 48 und über eine der Kugelumlaufführungen 46 an den Greiferarm 45 gekoppelt und dient bei dessen rückwärtiger Bewegung zur Einnahme der Ausgangslage für die Zugstange 47.

Zur Signal und Motorstromübertragung von der Versorgungseinheit 10 zu den Aktoren und Sensoren des Greifers 8 dienen Baugruppen 54, 55, 56, 57 mit federnden Kontakten 58, 59, 60, 61, die im Aufbau und in der Funktionsweise denen aus Fig. 1 bis 3 entsprechen.

Nicht dargestellt, jedoch ebenfalls in dieser Art und Weise aufgebaut und eine gleichartige Funktionsweise besitzend, sind auch am feststehenden und beweglichen Teil des Fahrstuhles derartige Baugruppen mit federnden Kontakten vorgesehen, mit denen eine Kontaktierung zwischen den Aktoren und Sensoren am beweglichen Teil und der Versorgungseinheit im feststehenden oder einer mit dem feststehenden Teil ebenfalls fest verbundenen Einheit ausschließlich in den Endlagen erfolgt.

Zur Verbindung der Beschickungseinrichtung mit einer Halbleiterbearbeitungsanlage oder einer beistellbaren Vorrichtung ist ein hier nicht näher beschriebenes mechanischen Interface vorgesehen.

Wie bereits in der DE-Patentschrift 43 26 309 C1 beschrieben, sind der Linearantrieb, der Fahrstuhlantrieb und der Antrieb für die greifenden Elemente des Greifers durch eine staubdichte Kapselung vom Reinstraum getrennt. An Öffnungen, durch die bewegte Objekte, wie der Greifer, seine greifenden Elemente und ein Element zur Aufnahme der Transportobjekte, das hier nicht näher beschrieben ist, in den Reinstraum ragen, grenzen Absaugeinrichtungen an.

## Patentansprüche

1. Beschickungseinrichtung für Halbleiterbearbeitungsanlagen, mit einem feststehenden Teil (1, 14, 42), in dem ein bewegliches Teil (17; 44, 45) geführt, zwischen zwei Endlagen durch einen Antrieb (7; 41) linear verschiebbar und an dem ein Greifer (8) drehbar befestigt ist, mit dem ein Transportobjekt (5) in einer Endlage des beweglichen Teiles (17; 44, 45) ergreifbar und nach Verschieben des beweglichen Teiles (17; 44, 45) in die andere Endlage dort absetzbar ist bzw. umgekehrt, wobei zwischen dem Greifer (8) und dem beweglichen Teil eine mechanische Koppeleinrichtung (18, 19, 20, 21; 47, 48, 50, 53) besteht, mittels derer mindestens während eines Abschnitts des Verschiebeweges des beweglichen Teiles dessen lineare Verschiebebewegung in eine Drehbewegung des Greifers (8) relativ zum beweglichen Teil (44, 45) bis zum Erreichen eines vorgegebenen, einstellbaren Verdrehwinkels umgesetzt wird.

2. Beschickungseinrichtung nach Anspruch 1, bei der der Greifer (8) drehbar an einem Greiferarm (17, 45) befestigt ist, der die Verbindung zu dem Antrieb (7, 41) bildet.

3. Beschickungseinrichtung für Halbleiterbearbeitungsanlagen nach Anspruch 2, bei der das feststehende Teil (1, 14) in Höhenrichtung verstellbar ist, die lineare Verschiebung des beweglichen Teiles (17) senkrecht hierzu verläuft und der Greifer (8) am Greiferarm (17) um eine senkrecht zur linearen Verschiebebewegung des beweglichen Teiles angeordnete sowie in einer zur Höhenverstellrichtung des feststehenden Teiles (1, 14) senkrechten Ebene liegende Achse (X-X) verdrehbar ist.

4. Beschickungseinrichtung nach Anspruch 3, bei der die mechanische Koppeleinrichtung (18-21) für den Greifer (8) einen mit dem Greiferarm (17) verbundenen ersten Hebel (18) aufweist, der während der linearen Bewegung des beweglichen Teiles eine Kulisse (19), die eine Höhendifferenz aufweist, abtastet und der über eine drehbar befestigte Schubstange (20) mit einem am Greifer (8) befestigten zweiten Hebel (21) zur Übertragung der Höhendifferenz und zur Umsetzung der linearen Bewegung in die Drehbewegung des Greifers (8) verbunden ist.

5. Beschickungseinrichtung nach Anspruch 4, bei der der erste Hebel (18) zur Einstellung des Verdrehwinkels des Greifers (8) in seiner wirksamen Hebellänge einstellbar ist.

6. Beschickungseinrichtung nach Anspruch 2, bei welcher das feststehende Teil in Höhenrichtung verstellbar ist, wobei der Greifer (8) am Greiferarm (45) um eine parallel zur Höhenverstellrichtung des feststehenden Teiles (14) liegende Achse (Y-Y) verdrehbar ist.

7. Beschickungseinrichtung nach Anspruch 6, bei der die mechanische Koppeleinrichtung eine in Kugelumlaufführungen (46) geführte und gelagerte Zugstange (47) aufweist, an der ein Mitnehmer (48) für eine am Greifer (8) in einer außermittig angeordneten Kugelgelenkverbindung (51) gelagerte Koppelstange (50) sowie ein erster Anschlag (49) befestigt sind, der bei der linearen Bewegung des Greiferarms (45) in Vorwärtsrichtung an einem zweiten, am feststehenden Teil (42) angebrachten Anschlag (53) zur Anlage kommt und dadurch bei Fortsetzung der linearen Bewegung des bewegten Teiles (44, 45) durch ein Zurückbleiben der Zugstange (47) und des Mitnehmers (48) eine Verdrehung des Greifers (8) verursacht.

8. Beschickungseinrichtung nach Anspruch 7, bei der die Kugelgelenkverbindung (51) ein federkraftbeaufschlagtes, justierbares Anschlagssystem aufweist.

9. Beschickungseinrichtung nach Anspruch 8, bei der der Ort des Beginns der Verdrehung und der Verdrehwinkel des Greifers (8) durch Veränderung der Befestigung sowohl des ersten Anschlages (49) an der Zugstange (47) als auch des zweiten Anschlages (53) am feststehenden Teil (42) oder durch Veränderung der Lage der Koppelstange (50) einstellbar ist.

10. Beschickungseinrichtung nach einem der Ansprüche 1 bis 9, bei der zur Steuerung der Funktionen des Greifers (8) eine elektrische Kontaktierung zwischen Sensoren und Aktoren des Greifers (8) und einer Versorgungseinheit (10) zur Signal- und Motorstromversorgung am feststehenden Teil (1, 14) ausschließlich in den beiden Endlage des beweglichen Teiles (17;44, 45) erfolgt.

11. Beschickungseinrichtung nach Anspruch 10, bei der zur elektrischen Kontaktierung Baugruppen (22-24, 54-57) mit federnden Kontakten (25-27, 58-61) vorgesehen sind, von denen das feststehende Teil in den Endlagen des beweglichen Teiles jeweils eine Baugruppe (22, 23; 54, 55) und das bewegliche Teil mindestens eine weitere Baugruppe (24, 56, 57) trägt, wobei die federnden Kontakte (25, 26, 58, 59) am feststehenden Teil, die elektrisch mit der Versorgungseinheit (10) verbunden sind, den federnden Kontakten (27, 60, 61) am beweglichen Teil, von denen elektrische Verbindungen zu den Sensoren und Aktoren bestehen, zugewandt sind.

12. Beschickungseinrichtung nach Anspruch 11, bei der die federnden Kontakte (25-27; 58-61) als Goldkontakte in Form von federnd in einer Hülse gehaltenen Goldstiften ausgebildet sind.

13. Beschickungseinrichtung nach einem der Ansprüche 1 bis 12, bei der für die lineare Bewegung des Greifers (8) ein pneumatischer Linearantrieb (7, 41) vorgesehen ist.

14. Beschickungseinrichtung nach Anspruch 13, bei der zur Geschwindigkeitssteuerung für jede Richtung der linearen Bewegung an dem Zylinder (15) des pneumatischen Linearantriebs (7, 41) mindestens ein Paar von parallel wirkenden Drosseln mit voneinander verschieden einstellbaren Luftdurchlaßmengen vorgesehen und die Anzahl der in Richtung der linearen Bewegung wirksam werdenden Drosseln in Abhängigkeit vom Ort des beweglichen Teiles und der Richtung der linearen Bewegung von Sensorsignalen gesteuert ist.

15. Beschickungseinrichtung nach Anspruch 14, bei der als Drosseln Drosselrückschlagventile (37-40) vorgesehen sind, mit denen die Drosselung von Abluft einstellbar ist und welche die Luft in Bewegungsrichtung ungehindert durchlassen.

## Claims

1. Feeding arrangement for semiconductor processing installations, with a stationary part (1, 14, 42) in which a movable part (17; 44, 45) is guided and can be displaced in a linear manner between two end positions by a drive (7; 41) and on which there is fixed rotatably a gripper (8) with which an object for transport (5) can be gripped in one end position of the movable part (17; 44, 45) and after displacement of the movable part (17; 44, 45) into the other end position can be set down there, or *vice versa*, wherein between the gripper (8) and the movable part there is a mechanical coupling arrangement (18, 19, 20, 21; 47, 48, 50, 53) by means of which at least during a portion of the displacement path of the movable part the linear displacement movement thereof is converted into a rotary movement of the gripper (8) relative to the movable part (44, 45) until a predetermined adjustable angle of rotation is reached.

2. Feeding arrangement as claimed in Claim 1, in which the gripper (8) is fixed rotatably on a gripper arm (17, 45) which forms the connection to the drive (7, 41).

3. Feeding arrangement for semiconductor processing installations as claimed in Claim 2, in which the stationary part (1, 14) is adjustable in height, the linear displacement of the movable part (17) runs perpendicular thereto and the gripper (8) on the gripper arm (17) is rotatable about an axis (X-X) which is disposed perpendicular to the linear displacement movement of the movable part and lies in a plane perpendicular to the direction of height adjustment of the stationary part (1, 14).

4. Feeding arrangement as claimed in Claim 3, in which the mechanical coupling arrangement (18-21) for the gripper (8) has a first lever (18) which is connected to the gripper arm (17) and which during the linear movement of the movable part senses a rocker (19) which has a height difference, the said first lever being connected by way of a rotatably fixed push rod (20) to a second lever (21) fixed on the gripper (8) in order to transfer the height difference and to convert the linear movement into the rotary movement of the gripper (8).

5. Feeding arrangement as claimed in Claim 4, in which the first lever (18) is adjustable in its effective lever length in order to adjust the angle of rotation of the gripper (8).

6. Feeding arrangement as claimed in Claim 2, in which the stationary part is adjustable in height, wherein the gripper on the gripper arm (45) is rotatable about an axis (Y-Y) lying parallel to the direction of height adjustment of the stationary part (14).

7. Feeding arrangement as claimed in Claim 6, in which the mechanical coupling arrangement has a tension rod (47) which is guided and mounted in recirculating ball guides (46) and on which are fixed an entraining element (48) for a coupling rod (50) mounted on the gripper (8) in an eccentrically disposed ball joint connection (51) as well as a first stop (49) which in the case of the linear movement of the gripper arm (45) in the forward direction comes to rest against a second stop (53) mounted on the stationary part (42) and thereby as the moving part (44, 45) continues its linen movement causes a rotation of the gripper (8) due to the tension rod (47) and the entraining element (48) staying back.

8. Feeding arrangement as claimed in Claim 7, in which the ball joint connection (51) has an adjustable stop system acted upon by spring force.

9. Feeding arrangement as claimed in Claim 8, in which the location of the start of the rotation and the angle of rotation of the gripper (8) is adjustable by alteration of the fixing both of the first stop (49) on the tension rod (47) and of the second stop (53) on the stationary part (42) or by alteration of the position of the coupling rod (50).

10. Feeding arrangement as claimed in one of Claims 1 to 9, in which for control of the functions of the gripper (8) electrical contact takes place between sensors and actors of the gripper (8) and a supply unit (10) for the signal and motor current supply on the stationary part (1, 14) exclusively in the two end positions of the movable part (17; 44, 45).

11. Feeding arrangement as claimed in Claim 10, in which for the electrical contact assemblies (22-24, 54-57) with resilient contacts (25-27, 58-61) are provided, of which the stationary part hears an assembly (22, 23; 54, 55) in each of the end positions of the movable part and the movable part hears at least one further assembly (24, 56, 57), wherein the resilient contact (25, 26, 58, 59) on the stationary part, which are electrically connected to the supply unit (10), are facing the resilient contacts (27, 60, 61) on the movable part from which there are electrical connections to the sensors and actors.

12. Feeding arrangement as claimed in Claim 11, in which the resilient contacts (25-27; 58-61) are constructed as gold contacts in the form of gold pins which are held resiliently in a sleeve.

13. Feeding arrangement as claimed in one of Claims 1 to 12, in which a pneumatic linear drive (7, 41) is provided for the linear movement of the gripper (8).

14. Feeding arrangement as claimed in Claim 13, in which for control of the speed for each direction of the linear movement at least one pair of parallel-acting throttles with air throughput quantities which can be adjusted differently from one another are provided on the cylinder (15) of the pneumatic linear drive (7, 41) and the number of throttles becoming effective in the direction of the linear movement is controlled by sensor signals as a function of the location of the movable part and the direction of the linear movement.

15. Feeding arrangement as claimed in Claim 14, in which throttle check valves (37-40) are provided as throttles with which the throttling of exhaust air is adjustable and which allow the air through unhindered in the direction of movement.

## Revendications

1. Dispositif de chargement pour des installations d'usinage de semiconducteurs, comportant une partie fixe (1, 14, 42) dans laquelle est guidée une partie mobile (17 ; 44, 45) qui est déplaçable linéairement entre deux positions de fin de course au moyen d'un dispositif d'entraînement (7 ; 41) et qui est fixée tournante à une pince (8) au moyen de laquelle un objet (5) à transporter peut être saisi dans une position de fin de course de la partie mobile (17 ; 44, 45) et peut être déposé dans l'autre position de fin de course, après déplacement de la partie mobile (17 ; 44, 45) dans cette autre position de fin de course ou inversement, entre la pince (8) et la partie mobile étant prévu un dispositif (18, 19, 20, 21 ; 47, 48, 50, 53) d'accouplement mécanique, au moyen duquel, sur au moins un tronçon de la distance de déplacement de la partie mobile, son mouvement de coulissement linéaire est converti en un mouvement de rotation de la pince (8) par rapport à la partie mobile (44, 45), jusqu'à ce que soit atteint un angle de rotation réglable, prédéterminé.

2. Dispositif de chargement selon la revendication 1, dans lequel la pince (8) est fixée, de manière à pouvoir tourner, sur un bras de pince (17, 45) qui constitue la liaison avec le dispositif d'entraînement (7, 41).

3. Dispositif de chargement pour des installations d'usinage de semiconducteurs selon la revendication 2, dans lequel la partie fixe (1, 14) est réglable en hauteur, le coulissement linéaire de la partie mobile (17) est perpendiculaire à cette direction en hauteur et la pince (8) peut tourner autour d'un axe (X-X) disposé perpendiculairement au déplacement en coulissement linéaire de la partie mobile et situé dans un plan perpendiculaire à la direction de réglage en hauteur de la partie fixe (1, 14).

4. Dispositif de chargement selon la revendication 3, dans lequel le dispositif (18-21) d'accouplement mécanique de la pince (8) comporte un premier levier (18) qui est relié au bras de pince (17) et qui, pendant le déplacement linéaire de la partie mobile, palpe une coulisse (19), présentant une différence de hauteur, et qui est relié, par une bielle (20), fixée tournante, à un deuxième levier (21) fixé à la pince (8), pour transmettre la différence de hauteur et pour convertir le mouvement linéaire en mouvement de rotation de la pince (8).

5. Dispositif de chargement selon la revendication 4, dans lequel le premier levier (18) est réglable dans sa longueur utile, en vue du réglage de l'angle de rotation de la pince (8).

6. Dispositif de chargement selon la revendication 2, dans lequel la partie fixe est réglable en hauteur, la pince (8) pouvant tourner sur le bras de pince (45), autour d'un axe (Y-Y) qui est parallèle à la direction de réglage en hauteur de la partie fixe (14).

7. Dispositif de chargement selon la revendication 6, dans lequel le dispositif d'accouplement mécanique comporte une barre de traction (47) guidée et montée dans des organes de guidage (46) à circulation de billes, à laquelle sont fixés un entraîneur (48) pour une barre d'accouplement (50), montée sur la pince (8) dans une liaison (51) à joint sphérique, disposée excentrée, ainsi qu'une première butée (49) qui, pendant le déplacement linéaire du bras de pince (45) vers l'avant, vient s'appliquer contre une deuxième butée (53) prévue sur la partie fixe (42), et de ce fait provoque une rotation de la pince (8), lorsque le déplacement linéaire de la partie mobile (44, 45) se poursuit, du fait du retard de la barre de traction (47) et de l'entraîneur (48).

8. Dispositif de chargement selon la revendication 7, dans lequel la liaison (51) à joint sphérique comporte un système de butée ajustable, soumis à la force d'un ressort.

9. Dispositif de chargement selon la revendication 8, dans lequel le lieu du début de la rotation et l'angle de rotation de la pince (8) sont réglables par modification de la fixation de la première butée (49) sur la baffe de traction (47) ainsi que de la deuxième butée (53) sur la partie fixe (42), ou par modification de la position de la barre d'accouplement (50).

10. Dispositif de chargement selon l'une des revendications 1 à 9, dans lequel pour commander les fonctions de la pince (8), il se produit une mise en contact électrique entre des capteurs et des actionneurs de la pince (8) et une unité (10) d'alimentation en courant de signalisation et en courant moteur sur la partie fixe (1, 14), exclusivement dans les deux positions de fin de course de la partie mobile (17 ; 44, 45).

11. Dispositif de chargement selon la revendication 10, dans lequel il est prévu, pour la mise en contact électrique, des ensembles (22-24, 54-57) avec des contacts (25-27, 58-61) élastiques, dont la partie fixe porte, dans chacune des positions de fin de course de la partie mobile, un ensemble (22, 23 ; 54, 55), et la partie mobile porte au moins un autre ensemble (24, 56, 57), les contacts élastiques (25, 26, 58, 59) sur la partie fixe et qui sont reliés électriquement à l'unité d'alimentation (10) étant tournés vers les contacts élastiques (27, 60, 61) sur la partie mobile dont des liaisons électriques avec les capteurs et actionneurs sont réalisées.

12. Dispositif de chargement selon la revendication 11, dans lequel les contacts élastiques (25-27 ; 58-61) sont réalisés en tant que contacts en or, sous la forme de broches en or maintenues élastiquement dans une douille.

13. Dispositif de chargement selon l'une des revendications 1 à 12, dans lequel un dispositif d'entraînement linéaire (7, 41) pneumatique est prévu pour le déplacement linéaire de la pince (8).

14. Dispositif de chargement selon la revendication 13, dans lequel il est prévu, pour la commande de la vitesse dans chaque sens du déplacement linéaire, sur le vérin (15) du dispositif d'entraînement linéaire (7, 41) pneumatique, au moins une paire d'organes d'étranglement agissant parallèlement, avec des débits d'air réglables différemment l'un de l'autre, et le nombre d'organes d'étranglement, qui opèrent dans la direction du déplacement linéaire, est commandé par des signaux de capteurs, en fonction de l'emplacement de la partie mobile et du sens du déplacement linéaire.

15. Dispositif de chargement selon la revendication 14, dans lequel il est prévu comme organes d'étranglement des clapets d'étranglement de non-retour (37-40), au moyen desquels l'étranglement de l'air évacué est réglable et qui laissent passer librement l'air dans le sens du déplacement.
